**Europäisches Patentamt**

(19) **European Patent Office**

**Office européen des brevets**

(11) Numéro de publication: **0 152 984**
**B1**

(12) # FASCICULE DE BREVET EUROPEEN

(45) Date de publication du fascicule du brevet: **28.12.88**

(51) Int. Cl.⁴: **G 01 R 19/175**, G 01 S 13/78

(21) Numéro de dépôt: **85200161.9**

(22) Date de dépôt: **11.02.85**

(54) **Dispositif pour déterminer l'instant du début du front avant d'une impulsion haute fréquence.**

(30) Priorité: **15.02.84 FR 8402284**

(43) Date de publication de la demande:
**28.08.85 Bulletin 85/35**

(45) Mention de la délivrance du brevet:
**28.12.88 Bulletin 88/52**

(84) Etats contractants désignés:
**DE FR GB**

(56) Documents cités:
**EP-A- 0 058 095**

**HEWLETT-PACKARD JOURNAL, vol. 28, no. 6, février 1977, pages 11-18, Palo Alto, US; J.E. McDERMID et a.: "A high-speed system voltmeter for time-related measurements"**
**Alta Frequenzia, vol. Li, no. 5, septembre-octobre 1982, pp. 242-256, Chiarini et al.: "A new technique for the precision DME of MLS"**

(73) Titulaire: **TELECOMMUNICATIONS RADIOELECTRIQUES ET TELEPHONIQUES T.R.T., 88, rue Brillat Savarin, F-75013 Paris (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB**

(72) Inventeur: **Tomasi, Jean-Pierre, SOCIETE CIVILE S.P.I.D. 209 rue de l'Université, F-75007 Paris (FR)**

(74) Mandataire: **Chaffraix, Jean et al, Société Civile S.P.I.D. 209, rue de l'Université, F-75007 Paris (FR)**

## Description

La présente invention concerne un dispositif pour déterminer l'instant $t_0$ du début du front avant d'une impulsion V haute fréquence reçue de forme:

$$V = A.(t - t_0).\sin 2\pi \, Ft \qquad (t > t_0)$$

où:

V est la tension instantanée
A est la pente (inconnue a priori) du front avant
t est le temps
F est la fréquence.

Les dispositifs de ce genre peuvent trouver d'importantes applications notamment dans le domaine de la radionavigation. On pourra à ce sujet consulter l'article de la revue ALTA FREQUENZIA, intitulé «A New Technique for the Precision DME of Microwave Landing System» de CHIARINI et autres, paru dans le volume LI n° 5 de Septembre–Octobre 1982. Dans cet article il est fait mention, au paragraphe 4, d'un dispositif du genre mentionné dans le préambule. Pour faire fonctionner correctement ce dispositif connu on doit s'imposer les exigences suivantes:

– il faut détecter l'impulsion selon une loi linéaire afin de respecter la linéarité de la pente du front avant;
– et il faut que la fréquence de l'impulsion avant détection soit élevée. En effet dans le domaine d'application envisagé, la durée de la partie linéaire du front avant n'est que de 300 ns alors que la précision demandée est de 30 ns environ. Pour obtenir cette précision il faut que la période de la haute fréquence soit inférieure à 30 ns, c'est-à-dire une fréquence supérieure à 30 MHz. Ceci interdit la technique pourtant avantageuse par ailleurs du deuxième changement de fréquence et de là le passage de la première fréquence intermédiaire (63 MHz) à la deuxième fréquence habituelle (10 MHz).

L'invention propose un dispositif pour déterminer l'instant du début du front avant d'une impulsion haute fréquence avec lequel on n'est pas confronté avec ces exigences. Pour cela il est remarquable en ce qu'il comporte un circuit de retard pour retarder l'impulsion reçue d'un laps de temps égal à k/2F (k entier) et pour fournir ainsi une deuxième impulsion $V_R$ de forme:

$$V_R = A \cdot (t - t_0 - \frac{k}{2F}) \cdot \sin 2\pi \left[ F(t - \frac{k}{2F}) \right]$$

et un circuit de calcul pour donner l'instant $t_0$ en effectuant le calcul:

$$t_0 = t - \frac{k(-1)^k V}{2F[(-1)^k V - V_R]}$$

L'invention propose aussi un dispositif pour déterminer l'instant du début du front avant d'une impulsion haute fréquence reçue comprenant des premiers et deuxièmes moyens de retard et tel que revendiqué à la revendication 8.

La description suivante, en regard des dessins annexés, le tout donné à titre d'exemple non limitatif, fera bien comprendre comment l'invention peut être réalisée.

La figure 1 représente un schéma d'un dispositif de l'invention.

Les figures 2 et 3 montrent l'allure du front avant de l'impulsion à 63 MHz et à 10 MHz respectivement.

La figure 4 montre un premier mode de réalisation du dispositif de l'invention.

La figure 5 montre un deuxième mode de réalisation du dispositif de l'invention.

La figure 6 montre un troisième mode de réalisation du dispositif de l'invention.

La figure 7 montre un schéma d'un autre dispositif conforme à l'invention.

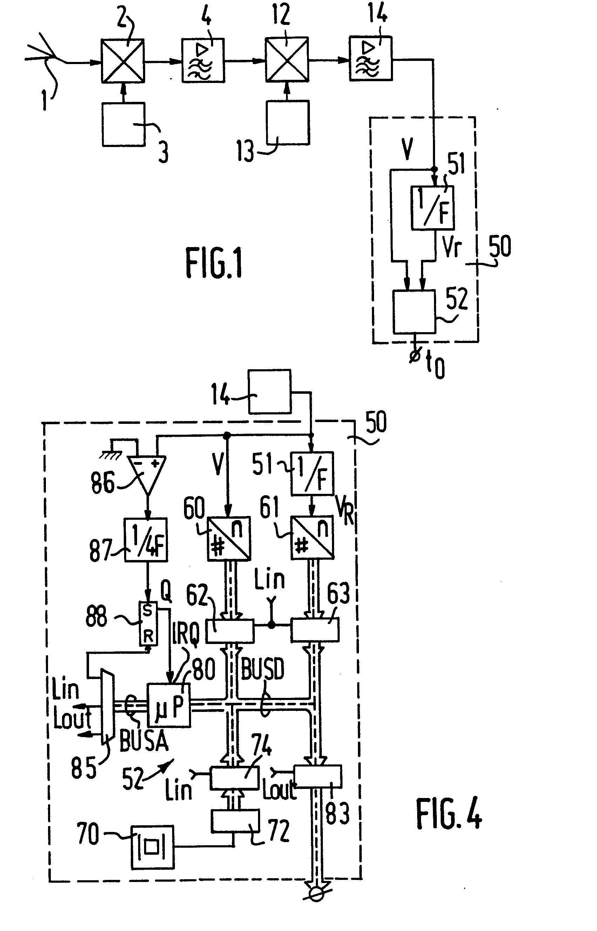

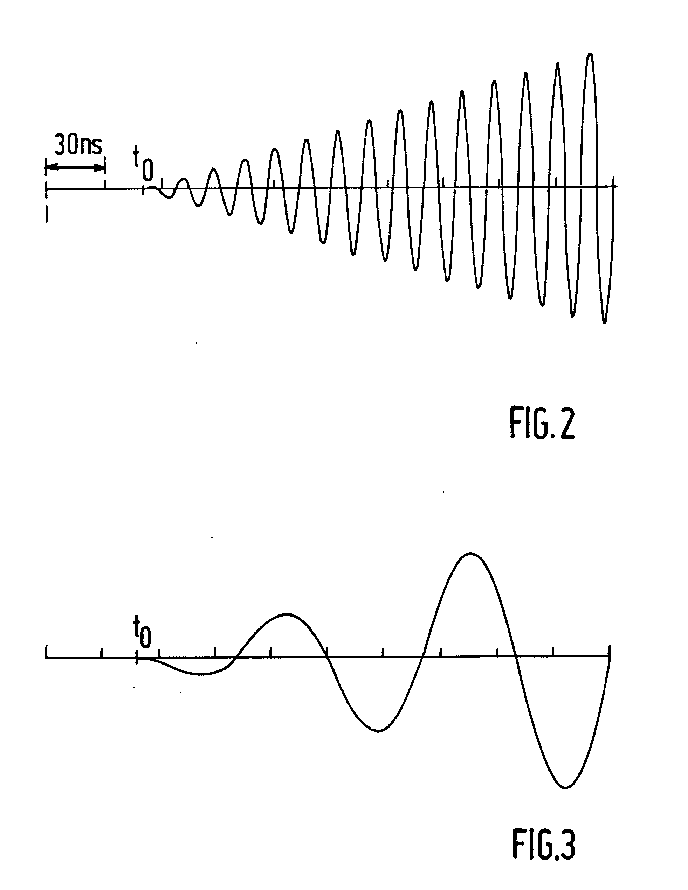

A la figure 1, la référence 1 indique une antenne captant l'onde dont la fréquence porteuse est de l'ordre du GHz. Après un premier changement de fréquence obtenu par un premier mélangeur 2 coopérant avec un premier oscillateur local 3, on obtient une fréquence intermédiaire de 63 MHz. La figure 2 représente l'allure du front avant d'une durée de 300 ns d'une impulsion à la sortie du mélangeur 2. Après passage dans un amplificateur 4, un deuxième changement de fréquence à 10 MHz est obtenu par un deuxième mélangeur 12 coopérant avec un deuxième oscillateur local 13 suivi d'un amplificateur sélectif 14. L'allure du front montant est représentée à la figure 3.

Avec le dispositif connu précité on détermine l'instant $t_0$ à partir de l'impulsion recueillie à la sortie du premier changement de fréquence où les signaux à traiter sont rapides; l'invention propose donc un dispositif où l'instant $t_0$ est déterminé par des signaux recueillis à la sortie du deuxième changement de fréquence où des signaux à traiter sont plus lents. Le front avant de cette impulsion peut s'écrire sous la forme:

(1) $\qquad V = A.(t - t_0).\sin 2\pi \, Ft \qquad (t > t_0)$

où

V est la tension instantanée
A est la pente (inconnue a priori) du front avant
t est le temps et
F est la fréquence (ici 10 MHz).

Conformément à l'invention, le dispositif 50 pour déterminer l'instant $t_0$ de début du front avant d'une impulsion haute fréquence comporte un circuit de retard 51 pour retarder l'impulsion reçue d'un laps de temps égal à k/2F (k entier) et pour fournir ainsi une deuxième impulsion $V_R$ de forme:

(2) $\quad V_R = A \cdot (t - t_0 - \frac{k}{2F}) \cdot \sin \left[ 2\pi F(t - \frac{k}{2F}) \right]$

et un circuit de calcul 52 pour donner l'instant $t_0$ en effectuant le calcul:

(3) $\qquad t_0 = t - \frac{k(-1)^k}{2F[(-1)^k V - V_R]}$

Pour justifier l'équation (3) il suffit de remarquer que:

$$\sin \left[ 2\pi F(t - \frac{k}{2F}) \right] = (-1)^k \sin 2\pi \, Ft$$

et que la relation (1) donne:

$$\sin 2\pi\, Ft = \frac{V}{A \cdot (t - t_o)}$$

De préférence, on prendra k = 2 de sorte que (3) s'écrira:

(4)     $$t_o = t - \frac{V}{F(V - V_R)}$$

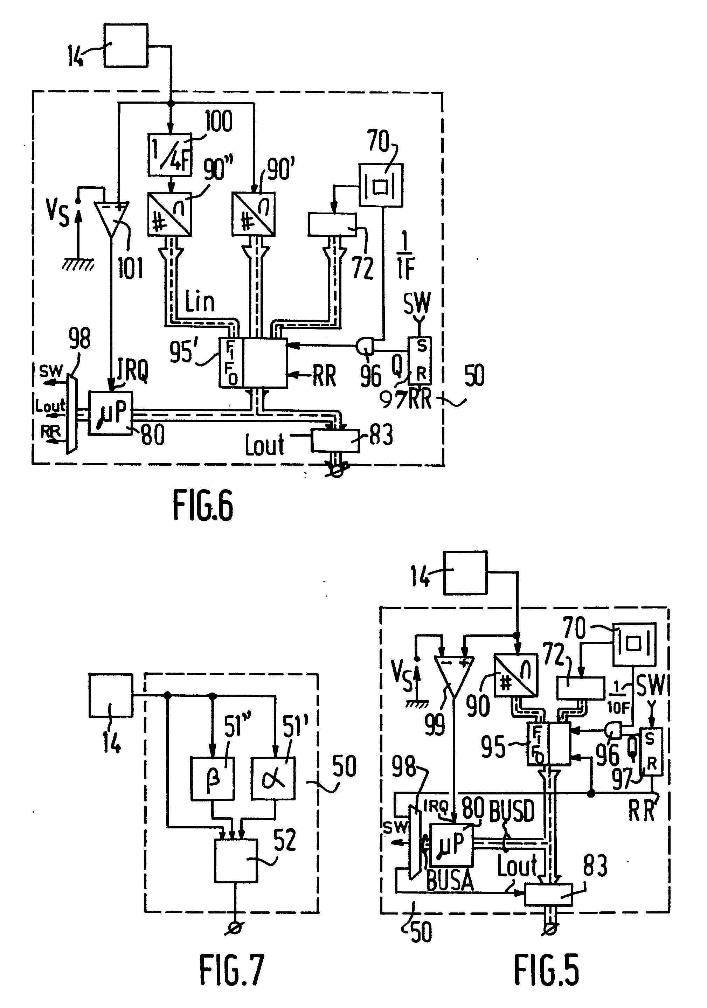

La figure 4 représente un mode de réalisation du dispositif de l'invention. Ce mode de réalisation comporte deux convertisseurs analogiques-numériques 60 et 61 l'un pour convertir le signal V et l'autre le signal $V_R$ à la sortie du circuit à retard 51. Les sorties numériques de ces convertisseurs 60 et 61 sont reliées à des registres tampons 62 et 63. Une horloge 70 fournit en permanence des signaux d'incrémentation à un compteur de temps 72 qui donne ainsi l'indication du temps «t». Les sorties en parallèle du compteur 72 sont aussi reliées à un registre tampon 74. Les registres 62, 63 et 74 munis d'une commande de chargement reliée à un fil $L_{in}$ servent d'interface au circuit de calcul 52 constitué à partir d'un ensemble de calcul à microprocesseur 80. Les sorties en parallèle des registres 62, 63 et 74 sont reliées à la ligne BUSD du microprocesseur 80. Un registre tampon 83 dont les entrées en parallèle sont reliées aussi à la ligne BUSD sert à contenir la valeur $t_o$ recherchée. Le microprocesseur comporte aussi une ligne BUSA pour véhiculer des codes d'adresses; chaque registre 62, 63, 74 peut être ainsi sélectionné pour être lu d'une manière non représentée; cependant un code particulier a été affecté pour que les commandes de chargement (fil $L_{in}$) des registres 62, 63 et 74 soient activées en même temps. Ceci est obtenu par un décodeur 85. Un autre code transmis dans un fil $L_{out}$ permet le chargement du registre 83. Pour déclencher le calcul indiqué par la formule (4), on attend un signal apparaissant sur l'entrée IRQ du microprocesseur 80. Ce signal est élaboré par un comparateur 86 suivi d'un deuxième circuit de retard de ¼ F portant la référence 87; ce comparateur fournit un signal actif dès que la tension V passe par la valeur «0». Le circuit de retard 87 permet d'assurer que les signaux V et $V_R$ aient une amplitude voisine du niveau maximum, lorsque le signal est appliqué à l'entrée S d'une bascule 88 de type RS. Le signal à la sortie Q de cette bascule 88 est appliqué à l'entrée IRQ du microprocesseur 80. A la réception de ce signal, le programme d'interruption est exécuté. Les registres 62, 63 et 74 sont chargés en même temps et le calcul indiqué à la formule (4) est exécuté; le résultat est ensuite chargé dans le registre 83. Il est évident que plusieurs calculs peuvent être exécutés. Pour cela, les registres 62, 63 et 74 seront chargés plusieurs fois et la valeur emmagasinée finalement dans le registre 83 sera la valeur moyenne de tous ces calculs. Le programme d'interruption peut encore commencer par des séries de lectures des registres 62, 63 et 74 et le calcul ne sera effectué que pour les valeurs les plus fortes contenues dans les registres 62 et 63. A la fin des calculs, un code d'adresse est engendré qui, décodé par le décodeur 85, provoque l'apparition d'un signal de remise à zéro à l'entrée R de la bascule 88.

La figure 5 montre un autre exemple de réalisation, les éléments communs avec ceux des figures précédentes portant les mêmes références. Dans cet exemple, un seul convertisseur numérique-analogique 90 est prévu. L'horloge 70 fournit aussi les signaux d'incrémentation au compteur de temps 72. Les données à la sortie du convertisseur 90 et à la sortie du compteur 72 sont emmagasinées dans une mémoire 95 du type première information entrée, première information sortie (mémoire FIFO). L'enregistrement de ces données s'effectue au rythme du signal de sortie d'une porte ET 96 recevant sur la première de ses entrées un signal de l'horloge 70 et sur l'autre, le signal de sortie Q d'une bascule 97 de type RS. Cette bascule 97 est mise à l'état «1» ou «0» sous la commande du microprocesseur 80; pour cela on a affecté deux codes d'adresses différents. Ces codes sont transmis par le bus BUSA vers un décodeur d'adresse 98 qui fournit deux fils SW et RR, les codes de mise à l'état «1» et à l'état «0» respectivement.

Dans cet exemple on choisit la fréquence de l'horloge 70 d'une manière telle qu'après une division de fréquence simple on puisse obtenir une fréquence multiple (par exemple 10) de la fréquence F (celle de la fréquence intermédiaire). C'est ce signal de période 1/10F qui est appliqué à ladite première entrée de la porte 96. Pour déclencher le fonctionnement du microprocesseur on utilise le signal de sortie d'un comparateur 99; ce signal appliqué à l'entrée IRQ du microprocesseur n'apparaît que si le signal à l'entrée (+) du comparateur connectée à la sortie de l'amplificateur 14 excède une valeur de seuil $V_s$ à l'entrée (−).

Dès qu'un signal actif est appliqué à l'entrée IRQ, le traitement débute par l'enregistrement dans la mémoire 95 des données à la sortie du convertisseur analogique-numérique 90 et du compteur de temps 72; pour cela la bascule 97 est mise à l'état «1» pour autoriser cet enregistrement au rythme de l'horloge 70. Après cette phase d'écriture, on traite les données emmagasinées dans cette mémoire 95. Un signal actif apparaît alors sur le fil RR ce qui met la bascule 97 à l'état «0» bloquant ainsi la porte 96 et rend disponibles à la sortie de la mémoire 95 les premières données enregistrées. On effectue l'opération indiquée par la formule (4) selon les critères déjà cités et l'on charge la valeur trouvée dans le registre 83. Bien que les données soient espacées dans le temps de 1/10F, les calculs sont effectués pour des couples de valeurs espacés de 1/F.

Le mode de réalisation montré à la figure 6 permet d'utiliser des conversions analogiques-numériques à un rythme beaucoup plus lent que le mode de réalisation montré à la figure 5. Pour cela, il comporte deux convertisseurs 90' et 90''; le premier est connecté directement à la sortie de l'amplificateur 14, le deuxième à la sortie d'un circuit de retard 100 amenant un retard de l'ordre de ¼F. L'entrée de ce circuit est connectée aussi à la sortie de l'amplificateur 14. Un comparateur 101 est connecté à l'entrée du circuit 100. Les données aux sorties des convertisseurs 90' et 90″ et du compteur 72 sont enregistrées par les signaux actifs à la sortie de la porte 96. Bien que le montage soit semblable à celui de la figure 5, ici, la cadence des signaux est au rythme de 1/F. Le fonctionnement du microprocesseur est déclenché dès que la tension à l'entrée du circuit 100 dépasse la valeur $V_S$. Ce fonctionnement commence par l'enregistrement pendant 300 ns dans la mémoire 95', de plus faible capacité que la mémoire 95, des différentes données. On choisit ensuite la série de valeurs fournies par l'un des convertisseurs 90' et 90″, celle qui donne les plus fortes valeurs et l'on effectue alors le calcul. Ce calcul devra, bien entendu, tenir compte du retard ¼F amené par le circuit 100 si c'est la série fournie par le convertisseur 90″ qui a été choisie.

Toujours dans le cadre de l'invention, on peut prendre des retards différents de k/F tels qu'amenés par le circuit 51. Dans ce cas, il faut prévoir un deuxième circuit de retard. Ainsi à la figure 7 on a représenté deux circuits de retard 51' et 51″ amenant des retards respectifs différents $\alpha$ et $\beta$. Les signaux de sortie de ces circuits 51' et 51″ sont appelés $V_\alpha$ et $V_\beta$ respectivement, le signal d'entrée appelé V; dans ce cas on écrit:

(5) $\quad V = A.(t - t_o).\sin 2\pi\, Ft$
(6) $\quad V_\alpha = A.(t - t_o - \alpha).\sin 2\pi\, F(t - \alpha)$
(7) $\quad V_\beta = A.(t - t_o - \beta).\sin 2\pi\, F(t - \beta)$

Dans ce cas le circuit de calcul 52' doit effectuer l'opération:

$$(8) \qquad t_o = t - V\frac{\cos 2\pi\, F\beta\,.\,\sin 2\pi\, F\alpha\,.\,\beta\; -\; \cos 2\pi\, F\alpha\,.\,\sin 2\pi\, F\beta\,.\,\alpha}{V_\alpha \sin 2\pi\, F\beta\; -\; V_\beta \sin 2\pi\, F\alpha\; -\; V \sin 2\pi\, F(\beta - \alpha)}\; .$$

## Revendications

1. Dispositif pour déterminer l'instant $t_o$ du début du front avant d'une impulsion haute fréquence reçue de forme:

$$V = A.(t - t_o).\sin 2\pi\, Ft \qquad (t > t_o)$$

où:
V est la tension instantanée reçue
A est la pente (inconnue a priori) du front avant
t est le temps
F est la fréquence,
caractérisé en ce qu'il comporte des moyens de retard pour retarder l'impulsion reçue d'un laps de temps égal à k/2F (k entier) et pour fournir ainsi une deuxième impulsion $V_R$ de forme:

$$V_R = A\,.\,(t - t_o - \frac{k}{2F})\,.\,\sin 2\pi\left[F(t - \frac{k}{2F})\right]$$

et des moyens de calcul (52) recevant V et $V_R$ pour donner l'instant $t_o$ en effectuant le calcul:

$$t_o = t - \frac{k(-1)^k V}{2F[(-1)^k V - V_R]}\; .$$

2. Dispositif pour déterminer l'instant $t_o$ du début du front avant d'une impulsion V haute fréquence, caractérisé en ce que k = 2.

3. Dispositif pour déterminer l'instant $t_o$ du début du front avant d'une impulsion V haute fréquence selon la revendication 1 ou 2, caractérisé en ce que les moyens de retard sont constitués par un circuit de retard (51).

4. Dispositif pour déterminer l'instant $t_o$ du début du front avant d'une impulsion V haute fréquence selon la revendication 1 ou 2, caractérisé en ce que les moyens de retard sont constitués par un circuit de prélèvement d'échantillons séparés dudit laps de temps, coopérant avec un circuit d'échantillonnage de l'impulsion reçue.

5. Dispositif pour déterminer l'instant $t_o$ du début du front avant d'une impulsion V haute fréquence selon l'une des revendications 1 à 4, caractérisé en ce qu'il est prévu un circuit de seuil (86, 99, 101) pour déclencher le circuit de calcul dès que la tension instantanée de l'impulsion reçue prend une certaine valeur.

6. Dispositif pour déterminer l'instant $t_o$ du début du front avant d'une impulsion V haute fréquence selon l'une des revendications 4 à 5, caractérisé en ce que la cadence d'échantillonnage de l'impulsion reçue est rapide par rapport à la fréquence F.

7. Dispositif pour déterminer l'instant $t_o$ du début du front avant d'une impulsion V haute fréquence selon l'une des revendications 4 à 5, caractérisé en ce que la cadence d'échantillonnage de l'impulsion reçue est de l'ordre de grandeur de la fréquence F.

8. Dispositif pour déterminer l'instant $t_o$ du début du front avant d'une impulsion haute fréquence reçue de forme:

$$V = A.(t - t_o).\sin 2\pi\, Ft \qquad (t > t_o)$$

où:
V est la tension instantanée reçue
A est la pente (inconnue a priori) du front avant
t est le temps
F est la fréquence
caractérisé en ce qu'il comporte des premiers moyens de retard (51') pour retarder l'impulsion reçue d'un laps de temps égal à $\alpha$ et pour fournir ainsi une impulsion $V_\alpha$ de forme:

$$V_\alpha = A.(t - t_o - \alpha).\sin 2\pi\, F(t - \alpha)$$

des deuxièmes moyens de retard (51″) pour retarder l'impulsion reçue d'un laps de temps égal à $\beta$ différent de $\alpha$ et pour fournir ainsi une impulsion $V_\beta$ de forme:

$$V_\beta = A.(t - t_o - \beta).\sin 2\pi\, F(t - \beta)$$

et des moyens de calcul (52) recevant V, $V_\alpha$ et $V_\beta$ pour donner l'instant $t_o$ en effectuant le calcul:

$$t_o = t - V \frac{\cos 2\pi\, F\beta\, .\, \sin 2\pi\, F\alpha\, .\, \beta\, -\, \cos 2\pi\, F\alpha\, .\, \sin 2\pi\, F\beta\, .\, \alpha}{V_\alpha \sin 2\pi\, F\beta\, -\, V_\beta \sin 2\pi\, F\alpha\, -\, V \sin 2\pi\, F(\beta - \alpha)}$$

## Claims

1. An arrangement for determining the starting instant $t_o$ of the leading edge of a received high-frequency pulse signal V of the form

$$V = A.(t - t_o).\sin 2\pi F t \qquad (t > t_o)$$

where:

V  is the instantaneous voltage
A  is the slope (which is unknown) of the leading edge
t  is the time
F  is the frequency,

characterized in that the arrangement comprises delay means for delaying the received pulse by a time equal to k/2F (where k is an integer) and for thus producing a second pulse $V_R$ of the form:

$$V_R = A.(t - t_o - k/2F).\sin 2\pi[F(t - k/2F)]$$

and calculating means (52) receiving V and $V_R$ for calculating the instant $t_o$ by performing the calculation:

$$t_o = t - \frac{k(-1)^k\, V}{2F[(-1)^k\, V - V_R]}$$

2. An arrangement for determining the starting instant $t_o$ of the leading edge of high-frequency pulse signal V, characterized in that k = 2.

3. An arrangement for determining the starting instant $t_o$ of the leading edge of a high-frequency pulse signal V as claimed in Claim 1 or 2, characterized in that the delay means are constituted by a delay circuit (51).

4. An arrangement for determining the starting instant $t_o$ of the leading edge of a high-frequency pulse signal as claimed in Claim 1 or 2, characterized in that the delay means are constituted by a sampling circuit taking samples separate from said time, and which cooperates with a sampling circuit for sampling the received pulse.

5. An arrangement for determining the starting instant $t_o$ of the leading edge of a high-frequency pulse signal V as claimed in one of the Claims 1 to 4, characterized in that it comprises a threshold circuit (86, 99, 101) for triggering the calculation circuit from the moment the instantaneous voltage of the received pulse assumes a certain value.

6. An arrangement for determining the starting instant $t_o$ of the leading edge of a high-frequency pulse signal V as claimed in one of the Claims 4 and 5, characterized in that the sampling rate of the received pulse signal is high relative to the frequency F.

7. An arrangement for determining the starting instant $t_o$ of the leading edge of a high-frequency pulse signal V as claimed in one of the Claims 4 and 5, characterized in that the sampling rate of the received pulse signal is of the order of magnitude of the frequency F.

8. An arrangement for determining the starting instant $t_o$ of the leading edge of a received high-frequency pulse signal V of the form:

$$V = A.(t - t_o).\sin 2\pi F t \qquad (t > t_o)$$

where

V  is the instantaneous voltage
A  is the slope (which is unknown) of the leading edge
t  is the time and
F  is the frequency,

characterized in that the arrangement comprises first delay means (51') for delaying the received pulse signal by a period of time equal to $\alpha$ and for thus producing a pulse signal $V_\alpha$ of the form:

$$V_\alpha = A.(t - t_o - \alpha).\sin 2\pi F(t - \alpha)$$

second delay means (51'') for delaying the received pulse signal by a period of time equal to $\beta$ different from $\alpha$ and for thus producing a pulse signal $V_\beta$ of the form:

$$V_\beta = A.(t - t_o - \beta).\sin 2\pi F(t - \beta)$$

and calculating means (52) receiving V, $V_\alpha$ and $V_\beta$ for calculating the instant $t_o$ by performing the calculation:

$$t_o = t - V \frac{\cos 2\pi\, F\beta\, .\, \sin 2\pi\, F\alpha\, .\, \beta\, -\, \cos 2\pi\, F\alpha\, .\, \sin 2\pi\, F\beta\, .\, \alpha}{V_\alpha \sin 2\pi\, F\beta\, -\, V_\beta \sin 2\pi\, F\alpha\, -\, V \sin 2\pi\, F(\beta - \alpha)}$$

## Patentansprüche

1. Anordnung zum Erfassen des Anfangszeitpunktes $t_o$ der Vorderflanke eines in der folgenden Form empfangenen HF-Impulses:

$$V = A.(t - t_o).\sin 2\pi\, F t \qquad (t > t_o)$$

wobei:

V  die empfangene Momentanspannung ist,
A  die (vorher unbekannte) Schräge der Vorderflanke ist,
t  die Zeit und
F  die Frequenz ist,

dadurch gekennzeichnet, dass die Anordnung Verzögerungsmittel aufweist zum Verzögern des empfangenen Impulses über einen Zeitraum gleich k/2F (k eine ganze Zahl) und zum ebenfalls Liefern eines zweiten Impulses $V_R$ mit der Form:

$$V_R = A.(t - t_o - k/2F).\sin 2\pi[F(t - k/2F)]$$

sowie Rechenmittel (52), welche die Werte V und $V_R$ erhalten, zum Ermitteln des Zeitpunktes $t_o$, durch das Durchführen der Berechnung:

$$t_o = t - \frac{k(-1)^k\, V}{2F[(-1)^k\, V - V_R]}$$

2. Anordnung zum Erfassen des Anfangszeitpunktes $t_o$ der Vorderflanke V eines HF-Impulses, dadurch gekennzeichnet, dass k = 2 ist.

3. Anordnung zum Erfassen des Anfangszeitpunktes $t_o$ der Vorderflanke V eines HF-Impulses nach Anspruch 1 oder 2, dadurch gekennzeichnet, dass die Verzögerungsmittel durch eine Verzögerungsschaltung (51) gebildet sind.

4. Anordnung zum Erfassen des Anfangszeitpunktes $t_o$ der Vorderflanke eines HF-Impulses V nach Anspruch 1 oder 2, dadurch gekennzeichnet, dass die Verzögerungsmittel durch eine Abtastwertschaltung mit um die Zeiträume auseinander liegenden Abtastwerten gebildet sind, wobei diese Schaltung mit einer Abtastwertschaltung für die empfangenen Impulse zusammenarbeitet.

5. Anordnung zum Erfassen des Anfangszeitpunktes $t_o$ der Vorderflanke eines HF-Impulses V nach einem der Ansprüche 1 bis 4, dadurch gekennzeichnet, dass eine Schwellenschaltung (86, 99, 101) vorgesehen ist zum Ausschalten der Rechenschaltung, wenn die Momentanspannung des empfangenen Impulses einen bestimmten Wert erreicht.

6. Anordnung zum Erfassen des Anfangszeitpunktes $t_o$ der Vorderflanke eines HF-Impulses V nach einem der Ansprüche 4 oder 5, dadurch gekennzeichnet, dass der Takt der Abtastung des empfangenen Impulses im Vergleich zu der Frequenz F schnell ist.

7. Anordnung zum Erfassen des Anfangszeitpunktes $t_o$ der Vorderflanke eines HF-Impulses V nach einem der Ansprüche 4 oder 5, dadurch gekennzeichnet, dass der Takt der Abtastung des empfangenen Impulses in der Grössenordnung der Frequenz F liegt.

8. Anordnung zum Erfassen des Anfangszeitpunktes $t_o$ der Vorderflanke eines empfangenen HF-Impulses mit der folgenden Formel:

$$V = A.(t - t_o).\sin 2\pi Ft \qquad (t > t_o)$$

wobei:

V die empfangene Momentanspannung ist,

A die (vorher unbekannte) Schräge der Vorderflanke ist;

t die Zeit und

F die Frequenz ist,

dadurch gekennzeichnet, dass die Anordnung erste Verzögerungsmittel (51') aufweist zum Verzögern des empfangenen Impulses über einen Zeitraum gleich $\alpha$ und zum ebenfalls Liefern eines Impulses $V_\alpha$ mit der Form:

$$V_\alpha = A.(t - t_o - \alpha).\sin 2\pi F(t - \alpha),$$

sowie zweite Verzögerungsmittel (51'') zum Verzögern des empfangenen Impulses um einen Zeitraum entsprechend $\beta$, der einen anderen Wert hat als der Zeitraum $\alpha$, und zum ebenfalls Liefern eines Impulses $V_\beta$ mit der folgenden Form:

$$V_\beta = A.(t - t_o - \beta).\sin 2\pi F(t - \beta)$$

und Rechenmittel (52), welche die Werte V, $V_\alpha$ und $V_\beta$ erhalten, zum Liefern des Zeitpunktes $t_o$, durch das Durchführen der Berechnung:

$$t_o = t - V \frac{\cos 2\pi F\beta . \sin 2\pi F\alpha . \beta - \cos 2\pi F\alpha . \sin 2\pi F\beta . \alpha}{V_\alpha \sin 2\pi F\beta - V_\beta \sin 2\pi F\alpha - V \sin 2\pi F(\beta - \alpha)} .$$

FIG.1

FIG.4

FIG.2

FIG.3

FIG.6

FIG.7

FIG.5